# EUROPÄISCHE PATENTSCHRIFT

(11) **EP 1 450 389 B1**
(45) Veröffentlichungstag und Bekanntmachung des Hinweises auf die Patenterteilung: **02.12.2009**
(21) Anmeldenummer: 04001306.2
(22) Anmeldetag: 22.01.2004
(51) Int. Cl.: H01J 27/04, H01J 27/18, H01J 27/20, H01J 41/10, H01J 27/22, H01J 37/08

(54) **Multi-Mode-Metall-Ionenquelle mit der Struktur einer Hohlkathoden-Sputter-Ionenquelle mit radialer Ionenextraktion**
Multimode ion source with a hollow cathode sputter ion source-like structure with radial ion extracion.
Source d' ions multimode avec une structure du genre cathode creuse à pulvérisation à extraction ionique radiale.

(30) Priorität: 19.02.2003 DE 10306936
(43) Veröffentlichungstag der Anmeldung: 25.08.2004
(73) Patentinhaber: GSI Helmholtzzentrum für Schwerionenforschung GmbH, 64291 Darmstadt (DE)
(72) Erfinder: Müller, Michael, Dr., 68199 Mannheim (DE); Janik, Jan, Prof. Ing., 84103 Bratislava (SK)

(56) Entgegenhaltungen:
- DE-A1- 10 010 706
- JP-A- 7 262 946
- US-A- 4 344 019
- WOLF B H ET AL: "DEVELOPMENT OF HEAVY ION SOURCES AT GSI" REVIEW OF SCIENTIFIC INSTRUMENTS, AIP, MELVILLE, NY, US, Bd. 61, Nr. 1, PART 2, Januar 1990 (1990-01), Seiten 406-408, XP000101525 ISSN: 0034-6748

## Beschreibung

Die Erfindung betrifft eine Multi-Mode-Metall-Ionenquelle, mit der Struktur einer Hohlkathoden-Sputter-Ionenquelle mit radialer Ionenextraktion die wahlweise als Gas-PIG, Sputter-PIG oder Dual-HCD-Ionenquelle betrieben werden kann. (PIG steht für Penning- oder Philips Ionizations Vacuum Gauge, siehe beispielsweise: "Ion Sources", Bernhard Wolf, CRC Press Inc., 1995, Seite 69, Absatz 5.1.; HCD steht für Hollow Cathode Discharge, siehe ebenfalls in dem zitierten Buch Seite 54, Absatz 3.4.2.)

In der EP 0 967 628 A2 wird eine 2,45 GHz-ECR-Ionenquelle vorgestellt, die für große Beschleunigeranlagen konzipiert war. Die Ionenquelle hat ein zentral und axial ausgerichtetes mikrowellentransparentes Rohr, das in Flanschen vakuumdicht gelagert ist. Eine zylindrische Kavität, die in ihrer Geometrie an der Mikrowellenlänge orientiert ist, umschließt den Vakuumeinschluss zentrisch. Ein Hohlleiter mit definierter Formgebung zur Einspeisung der Mikrowelle trifft rechtwinkelig und zentral auf die Kavität und bildet den Einkoppel-schlitz. Eine Kühlgaszufuhr leitet einen Kühlgastrom zwischen dem Rohr des Vakuumeinschlusses und der Kavität zur Austrittsöffnung in der Kavität.

In der DE 697 11 764 T2 wird eine Vorrichtung zur Erzeugung eines Magnetfeldes B an einer ECR-Quelle beschrieben. Mit dieser Quelle werden Ionen erzeugt. Die Vorrichtung besteht aus einer Anordnung von N Magnetsystemen mit axialer Symmetrie zur Bildung eines axialen Magnetfeldes. Die N Systeme sind koaxial und ineinander verschachtelt. Die Anordnung magnetischer Mittel ermöglicht es ein radiales Magnetfeld zu erhalten. Die magnetischen Mittel sind im Innern der N Magnetsysteme angeordnet und koaxial zu diesen.

Eine gepulste magnetische Öffnung von Elektronen-Zyklotron-Resonanz-Ionenquellen zur Erzeugung kurzer, stromstarker Pulse hochgeladener Ionen oder Elektronen wird in der DE 199 33 762 A1 vorgestellt. Durch plötzliches Herunterschalten des magnetischen Einschlussfeldes im Bereich der Extraktion einer mit symmetrischen, axialen Magneteinschlussbetriebenen Ionenquelle, d.h. durch plötzliche und vollständige Öffnung des magnetischen Einschlusses im Bereich der Extraktion, bewegt sich das ganze Plasma plötzlich zur Extraktionsöffnung, so dass dort die extrahierten Ionenströme plötzlich vergrößert werden. Der große Ionenstrompuls dauert entweder bis sich der Plasmavorrat erschöpft hat oder bis der magnetische Einschluss wieder eingeschaltet wird. Statt Ionenstrompulse können auch E-lektronenstrompulse extrahiert werden.

Penning Ionenquellen werden u.a. auch an Schwerionen - Linearbeschleunigern als flexible und zuverlässige Werkzeuge eingesetzt, obwohl sie einst als leistungsstarke Ionenquellen für Zyklotrone entwickelt wurden.
Die typische Eigenschaft dieser Ionenquellen ist:
Bei Erhöhung der Entladungsleistung steigen nicht nur die Intensitäten des extrahierten Ionenstrahls an, gleichzeitig wird eine Verlagerung der Ladungszustandsverteilung hin zu höheren Ladungen beobachtet. Die Erzeugung sehr hoher Ionenstrahlströme in niedrigsten Ladungszuständen erscheint demnach problematisch. Die Problematik steigt naturgemäß mit der Ordnungszahl der zu erzeugenden Ionen an. Niedere Ladungszustände, z.B. Pb¹⁺, von sehr schwereren Ionen stehen daher von solchen Quellen in nur magerer Ausbeute zur Verfügung (siehe unten Figuren zu den Spektren Schwach-Starkfeld).

Im Hochstromszenario moderner Schwerionenbeschleuniger, z.B. Beschleuniger der Gesellschaft für Schwerionenforschung in Darmstadt (GSI), werden bis zum Element Cu einfach geladene Ionen verwendet. Trotz der Tatsache, dass für die Beschleunigeranwendung höhere Ladungszustände immer benützt werden können, liefert ein Strahl einfach geladener Ionen im Hinblick auf den gemessenen elektrischen Strom die maximale Teilchenzahl pro Puls oder Zeiteinheit. Diese Eigenschaft wird schon in der älteren Anmeldung (siehe DE 100 10 706) beschrieben.

Zur Ionenerzeugung ist zunächst die Bereitstellung freier Teilchen erforderlich.
Dazu wird in Penning-Ionenquellen häufig mit der Kathodenzerstäubung, Fachausdruck: Sputtering, gearbeitet. Diese Methode ist im Vergleich zu thermischen Techniken (Verdampferöfen) sehr bequem, da der Prozess praktisch bei Zimmertemperatur abläuft und somit die meisten der Probleme, die bei höheren Temperaturen auftreten, vermieden werden können.

Trotz des hocheffizienten Sputterings, ist der Wirkungsgrad zur Erzeugung von Metallionen mit Hilfe der Penning-Ionenquelle wegen der hohen Geschwindigkeit (5 bis 20 eV) der gesputterten Teilchen ziemlich klein ( « 1%) Ein Materialverbrauch von mehreren hundert Milligramm pro Stunde, abhängig von dem speziellen Element und von der Strahlintensität, ist typisch für Metallionenstrahlen für Pulsströme im mA-Bereich. Der größte Teil des gesputterten Materials durchquert die Plasmasäule als neutrale Teilchen und wird an den Wänden, bei der klassischen Penningquellen Geometrie an den Innenwänden des Anodenkanals, gestoppt und ist somit unmittelbar für weitere Sputter- und Ionisationsprozesse verloren.

Die übliche Geometrie der Sputter-Penning-Ionenquelle, wie sie beispielsweise bei GSI eingesetzt wird, zeigt eine unerfreuliche Zeitabhängigkeit der Ionenstrahlintensität entsprechend der Veränderungen in der Geometrie durch den Sputterprozess. Durch Materialabtragung nimmt während des Betriebs der Ionenquelle der Abstand zwischen Plasma und Sputterelektrode zu, und der dadurch bedingte Abfall der Metallionenstrahlintensität muss durch die kontinuierliche Erhöhung der Sputterspannung ausgeglichen werden.
Diese nachteiligen Eigenschaften: kleiner Wirkungsgrad und geometrische Instabilität, können durch die Verwendung einer koaxialen Sputterelektrode, die das Plasma nahezu vollständig umgibt, vermieden werden. Teilchen, welche beim Durchqueren der Plasmasäule nicht ionisiert werden, treffen größtenteils auf die Innenwand der Sputterelektrode und stehen dort für nachfolgende Sputterprozesse zur Verfügung.

Der Erfindung liegt die Aufgabe zugrunde, eine Metallionenquelle für nahezu alle metallischen Elemente des Periodensystems bereitzustellen, welche wahlweise auch in Compact-Bauweise als Penning-Ionenquelle für intensive Ionenstrahlen von höheren Ladungszuständen oder als Hohlkathoden-Sputter-Ionenquelle, HCD, für hohe Ionenstrahlströme in niedrigen Ladungszuständen betrieben werden kann.

Die Aufgabe wird durch eine Multi-Mode-Metall-Ionenquelle mit der Struktur einer Hohlkathoden-Sputter-Ionenquelle mit radialer Ionenextraktion (siehe die Struktur einer solchen Quelle beispielsweise aus der DE 100 10 706), die aber jetzt wahlweise durch elektrische Verschaltung der Elektroden als Gas-PIGoder Sputter-PIG- oder Dual-HCD- Ionenquelle betrieben werden kann, gemäß den Merkmalen des Anspruchs 1 gelöst.

Zwecks Stabilisierung und örtlicher Reproduzierbarkeit der Plasmaachse wird die Ionenquelle in einem magnetischen Spiegelfelde betrieben. Der Querschnitt des Spiegelfeldes in der Mittelebene zwischen den Polen hat zwei zueinander senkrecht stehende Hauptachsen, die Längs- und Querachse. Die Querachse fällt mit der Extraktionsachse des Ionenstrahl zusammen. Im Bereich des Spiegelfeldes sitzt zur Mittenebene des magnetischen Spiegelfeldes die symmetrische Elektrodenanordnung. Die Magnetfeldachse fällt mit der Achse der Entladungsgeometrie zusammen.

Die Elektrodenanordnung besteht aus zwei Kathoden, wovon wenigstens eine beheizbar ist, zwei Anoden zwischen diesen Kathoden zur zweiseitigen Initiierung eines Plasmas bzw. zur Bildung der Plasmasäule einer Penning-Entladung durch die Antikathode hindurch zwischen den beiden Kathoden. Dieses ist möglich, weil die hohe Plasmadichte die äußere Potentialverteilung abschirmt. Die pendelnden Elektronen der Penning-Entladung werden auf dem Wege entlang der Magnetfeldachse erst wieder bei Annäherung an die reflektierende Spiegelkathode abgebremst.

Die Antikathode ist mit drei achsenparallelen Spalten versehen, wovon durch den mittleren Spalt hindurch Metallionen aus der Plasmasäule durch die Extraktionselektrode radial extrahiert werden. Durch die verbleibenden einander gegenüberliegenden Spalte ragt jeweils eine elektrisch isolierte Sputterelektrode, die in ihrem jeweiligen Stirnbereich einen Querschnitt derart hat, dass jede Stirnfläche bündig zur Innenwand der Antikathode sitzt. Die einander gegenüberstehenden Sputterelektroden ermöglichen einen effizienzoptimierten Betrieb der klassischen Sputter-Penning-Ionenquelle, weil das gesputterte, nichtionisierte Material von einer Elektrode sich auf der gegenüberliegenden Elektrode niederschlägt, und vice versa, und bleibt somit nachfolgenden Sputter- und Ionisationsprozessen erhalten.

Zum Umschalten auf eine vorgegebene Betriebsweise sind die Elektroden über eine Schalteinrichtung, bestehend aus vier Schaltern, verknüpft. Zwei der vier Schalter liegen auf kathodischem Potential, die andern beiden auf anodischem Potential. Mit diesen vier Schaltern werden zwei Schaltergruppen gebildet, bei denen jeweils ein Schalter auf Kathodenpotential mit einem auf Anodenpotential direkt verbunden ist. Der Schaltzustand der beiden Gruppen ist zueinander stets komplementär. Die Sputterelektroden sind an die eine Schalterverbindung zwischen Anode und Kathode und die Antikathode an die andere Schalterverbindung angeschlossen.

Für grundsätzliche Untersuchungen, Machbarkeit für den Gebrauch als Injektionsionenquelle am UNILAC (Beschleuniger bei der GSI-Darmstadt), wurde die Entladungsgeometrie im starken, homogenen Magnetfeld der Penning-Ionenquelle am Injektor des UNILAC betrieben. Hier erfordert es die Kopplung des Magnetfelds und der Extraktionsspannung die Magnetfeldstärke auf 0,8 T anzuheben, wenn beispielsweise Mo²⁺-Ionen bei einer Spannung von ca. 13 kV extrahiert werden sollen. Die beobachtete Ladungsverteilung ist ähnlich der einer klassischen PIG-Ionenquelle. Ladungszustände bis zu Mo ⁵⁺ und wahrscheinlich höher wurden in bedeutsamen Quantitäten erzeugt. Beispielsweise wurde für den Ladungszustand Mo²⁺ unmittelbar nach der Ladungsanalyse ein Ionenpulsstrom von etwa 6 mA gemessen. Die andern Ladungszustände treten in der selben Größenordnung auf (siehe Figur. Spektrum Ar-Mo 0,5 T).

Um die Vorteile einer "Compact"-Geometrie (siehe oben) mit den vorteilhaften Eigenschaften der Penning-Entladung in der D-HCD-Ionenquelle zu kombinieren, ist ein Ionenquellenmagnet mit wesentlich höheren Flussdichten erforderlich. Der einfache Dipolmagnet mit quadratischen Polschuhe für die in der DE 100 10 706 beschriebenen Dual-HCD-Ionenquelle erlaubt eine maximale Flussdichte von 0,15 T in der Mittelebene des 16 cm langen Luftspaltes.

Eine planare oder zweidimensionale Geometrie des Magneten für das Quellenfeld erlaubt, in der Mittelebene die notwendige Feldstärke von etwa 0,5 T zu erzeugen. Das Längen- zu Breitenverhältnis der ebenen Polschuhfläche liegt hier im Bereich von 1 : 6. Das ist ausreichend, um auf der Achse eine hohe Plasmadichte zur Initiierung des Elektronenpendeleffekts für die Erzeugung hochgeladener Ionen in der Penning-Entladung zu erzeugen.

In den Unteransprüchen 2 bis 4 sind Aufbaumerkmale beschrieben, mit denen die Multi-Mode-Metall-Ionenquelle für eine wahlweise bevorzugte Betriebsweise ausgerüstet ist. Die Einrichtung zum Erzeugen des magnetischen Spiegelfeldes ist konstruktiv derart gestaltet, dass der Querschnitt des Spiegelfeldes rechteckig oder approximativ elliptisch ist. Das kann durch die geometrische Form der beiden Polschuhe beeinflusst werden, da an ihnen ja das Spiegelfeld beginnt.

In Anspruch 2 ist die Einrichtung zum Erzeugen des magnetischen Spiegelfeldes derart konstruiert, dass der Querschnitt des Spiegelfeldes rechteckig flach bis elliptisch/oval rund sein kann, und zwar so, dass die Längsachse des Querschnitts die Extraktionsachse senkrecht überquert und die Querachse parallel dazu liegt.

Zur Führung des Magnetfeldes außerhalb des Spiegelfeldes besteht die Einrichtung zum Erzeugen des magnetischen Spiegelfeldes aus einem Eisenjoch/-kern in C-Form oder aus einer Doppel-C-Form, wobei die beiden C in einer Ebene spiegelbildlich zueinander liegen und die beiden Polschuhe gemeinsam haben (Anspruch 3).

Sofern zwischen der Elektrodenanordnung und den beiden Magnetfeldpolen eine hochspannungsfeste Folie gelegt wird, kann die Stromversorgung für den Magneten auf Erdpotential gelegt werden (Anspruch 4), fordert aber eine ausreichende Größe des Luftspalts. Wird die Stromversorgung des Magneten elektrisch hochgelegt, kann der Luftspalt aufgrund der nicht notwendigen Isolation kleiner gehalten und damit eine höhere Feldstärke erreicht werden, der Leistungsaufwand bleibt dann bei gleicher Feldstärke verringert.

In der neuen Entladungsgeometrie ist der Mittelteil der Anode der klassischen Penning-Ionenquelle durch die elektrisch isolierte, zylindrische Sputterelektrode ersetzt, aus welcher der Ionenstrahl, wie vordem aus der Hohlanode der Penning- Ionenquelle, extrahiert wird. Die Entladungsgeometrie ist identisch mit der Hohlkathoden-Entladungsquelle (siehe DE 100 10 706).

Der Hauptunterschied zu herkömmlichen Hohlkathoden-Ionenquellen (HCD) ist in den Anodenplasmen zu sehen. Beim Betrieb im "schwachen" magnetischen Spiegelfeld überwiegt der Modus der Hohlkathodenentladung (siehe Figur Spektrum Schwachfeld Xe-Molybdän). Trotz der magnetischen Spiegelfeldverteilung kann sich die typische oszillierende Penning-Entladung nicht ausbilden, da der Hauptanteil der Elektronen vor Beginn der Oszillationsbewegung auf die Wände der Entladungskammer trifft. Die Umgehung dieser geometrischen Beschränkung durch Vergrößerung des Entladungsraumdurchmessers ist wegen der radial stark abfallenden Plasmadichte keine empfehlenswerte Lösung.

Im ausreichend starken homogenen magnetischen Feld ändern sich die Betriebseigenschaften der Ionenquelle. (Fig.: Spektrum Molybdän Starkfeld.) Offensichtlich schirmt das dichte Plasma nahe der Achse die äußere aufgeprägte Potentialstruktur ab, so dass sich eine stabile Penning-Entladung auf der Achse ausbilden kann. Der Vorteil der koaxialen Sputterkathode bleibt erhalten und führt zu einer Erhöhung der Materialeffizienz um etwa zwei Größenordnungen und/oder verlängert gleichzeitig die Lebensdauer der Ionenquelle.

Der Vorteil des Plasmafokussierens, welches der Grund für die gute Reproduzierbarkeit der Betriebsbedingungen in der C(ompact)-PIG-Umgebung ist, muss im Fall des homogenen Felds aufgegeben werden.

Die Struktur der Ionenquelle lässt vorteilhaft flexible Betriebsweisen zu:
- So kann durch die CPIG-Bauweise eine Extraktionsspannung bis 30 kV leicht beherrscht werden.
   Bei älteren PIG -Konstruktionen limitierte oft der Polschuhabstand des Ionenquellenmagneten die Extraktionsspannung auf 15 kV. Die Plasmadichte einer Penningionenquelle erlaubt jedoch weit höhere Feldstärken für die Ionenextraktion.
Weiterer Vorteil der neuen Anordnung sind:
- Die Magnetfelder für die Entladung und für die Ionenstrahlanalyse sind separiert.
   Dadurch ergeben sich mehr Freiheitsgrade für die Strahlführung des extrahierten Ionenstrahls.
- Das symmetrische Spiegel-/Flaschenfeld für die Entladung verbessert die Reproduzierbarkeit der Entladungsparameter und der Strahlerzeugung.
- Die Hohlkathodengeometrie, hier D-HCD, steigert die Materialeffizienz etwa um den Faktor 100 im Vergleich mit klassischen Penningquellen.
   Dadurch wird bei erheblich geringerem Materialverbrauch u.a. eine wesentlich höhere Betriebsdauer erreicht.
- Die Ionenquelle kann bei schwachen Magnetfeldern (< 0,15 T) als Hohlkathoden-Ionenquelle, D-HCD, für hohe Ströme niedrig geladener Ionen betrieben werden.
- Im Penning -Mode liefert der Betrieb der Ionenquelle bei stärkeren Quellenmagnetfeldern ab 0,5 T hohe Ströme höher geladener Ionen bei erheblich besserer Effizienz gegenüber älteren PIG-Versionen.
- Die planere Geometrie macht die Vorzüge der Compakt-Bauweise (C-PIG) mit wenig konstruktivem Aufwand für den Betrieb als Penning-Ionenquelle möglich.
- Durch einfache Beschaltung der Ionenquellenelektroden auch im laufenden Betrieb sind die klassischen Betriebsarten: Gas-PIG, oder Sputter-PIG je nach Bedarf wählbar.
- Die Variation der Magnetfeldstärke von "schwach", ~ 0,1 T, nach "stark", ~ 0,5 T, erlaubt vom Hohlkathoden- in den Penning-Modus zu wechseln.

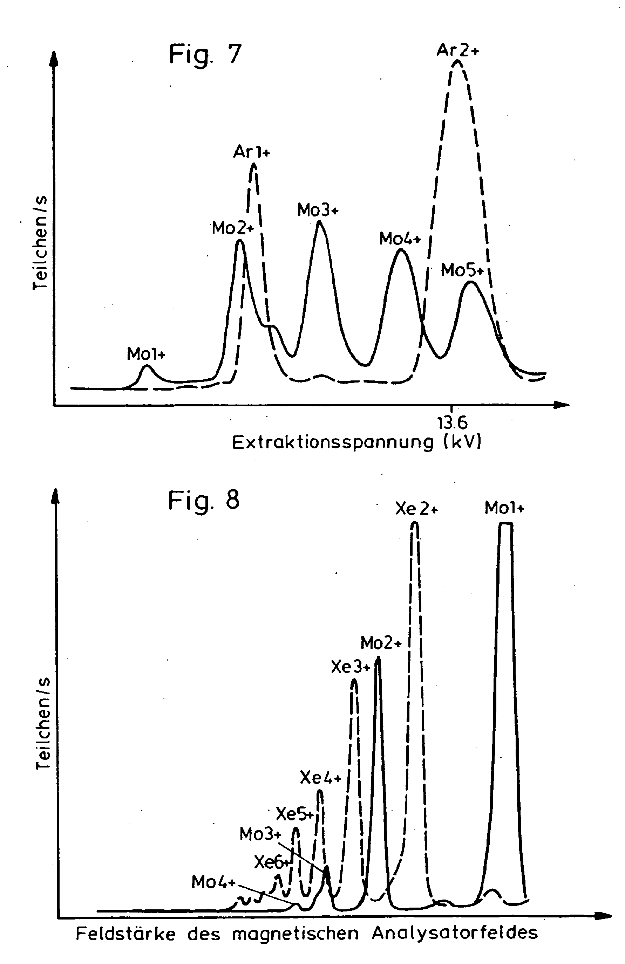

Im Hohlkathodenentladungsmodus arbeitet die Ionenquelle praktisch nur als Sputterionenquelle. Bei hoher Entladungsleistung werden im Ladungszustandsspektrum die Linien der Ionen des Trägergases stark unterdrückt, und es sind fast ausschließlich Linien der Metallionen von der Hohlkathode zu beobachten (siehe in den Figuren 7 und 8 das Molybdänspektrum).

Durch die wahlweise elektrische Beschaltung der Elektroden der Quelle kann während des Betriebs in den Penningentladungsmodus umgeschaltet werden. Nach einer Abklingphase von ca. 50 Pulsen sind die Metallionenlinien verschwunden, die Linien des Trägergases dominieren (siehe Figuren 7 und 8).

Im Penningentladungsmodus können zusätzlich eine oder zwei Sputterelektroden durch Potentialbeaufschlagung hinzugeschaltet werden. Als Resultat erscheint die bekannte Metallionen-Ladungsverteilung der Sputter-Penningquelle: Linien von Ionen des Trägergases und Linien der Metallionen erscheinen gleichzeitig im Spektrum.

Die beiden Entladungsmodi, Hohlkatoden-Entladung und Penning-Entladung, dienen:
im ersten Fall bei einem magnetischen Quellenfeld von 0,1 bis 0,5 T mit CPIG-Magnet oder Planarmagnet für niedrig geladene Ionen aus dem Material der Sputterelektrode;
im zweiten Fall bei einem magnetischen Quellenfeld ab 0,5 T mit Planarmagnet oder in einem homogenen, ausgedehntem Feld zur Erzeugung höher geladener Ionen aus dem Material der Sputterelektrode.

Die Eigenschaften der Multi-Mode-Metall-Ionen-Quelle sind zusammengefasst:

| | |
|---|---|
| hohe Materialeffizienz in allen Betriebsarten | (Sputter-Hohlkathode), |
| hohe Ionenströme bei höheren Ladungszuständen | (Sputter-Penning), |
| hohe Strahlintensität bei niedrigen Ladungszuständen | (D-HCD-Mode), |
| hohe Extraktionsspannung | (bis 30 kV) und |
| gute Reproduzierbarkeit der Betriebsparameter | (Plasmafokusierung im magnetischen Flaschenfeld). |

Eine mögliche Ausführungsform der Multi-Mode-Metal-Ionen-Quelle ist in der Zeichnung dargestellt und wird anhand dieser im folgenden näher beschrieben.
Es zeigen:
- Figur 1: Anordnung der Elektrodengeometrie im Feld des Planarmagneten, beispielhafte Geometrie des Planaren Magneten,
- Figur 2: die Feldverteilung in der Mittelebene des planaren Magneten,
- Figur 3: die Elektrodenanordnung der Multi-Mode-Metall-Ionen-Quelle,
- Figur 4: die Potentialbeaufschlagung für den D-HCD-Betrieb,
- Figur 5: die Potentialbeaufschlagung für den PIG-Betrieb,
- Figur 6: die elektrische Verschaltungseinrichtung,
- Figur 7: Ladungszustandsspektrum Ar-Mo bei 0,5 T,
- Figur 8: Ladungszustandsspektrum Xe-Mo bei 0,15 T.

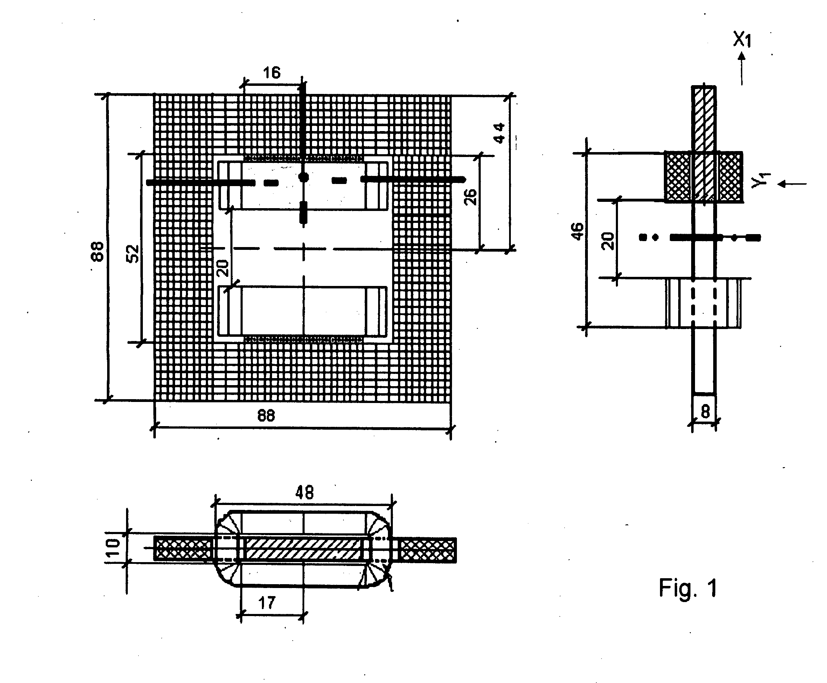

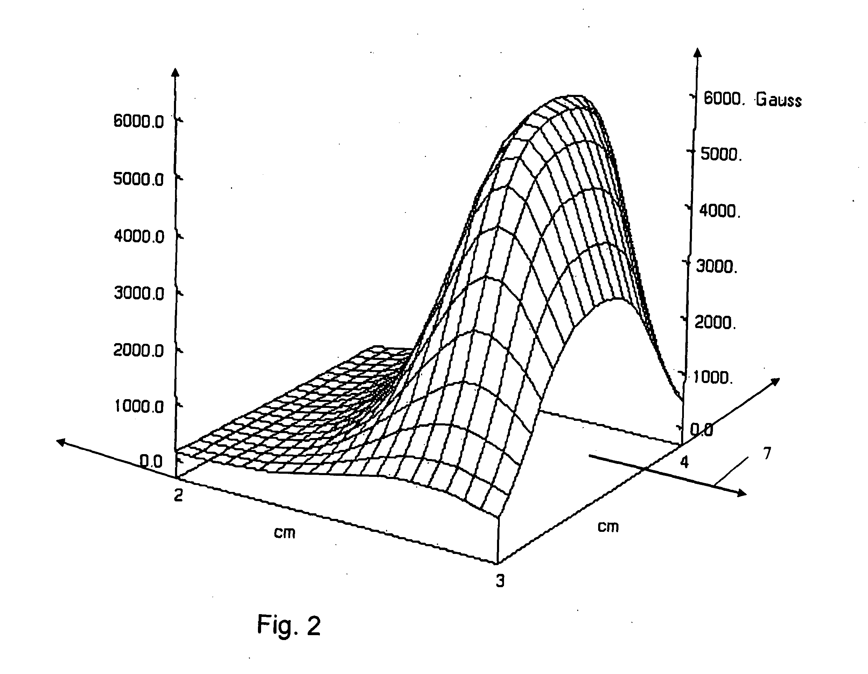

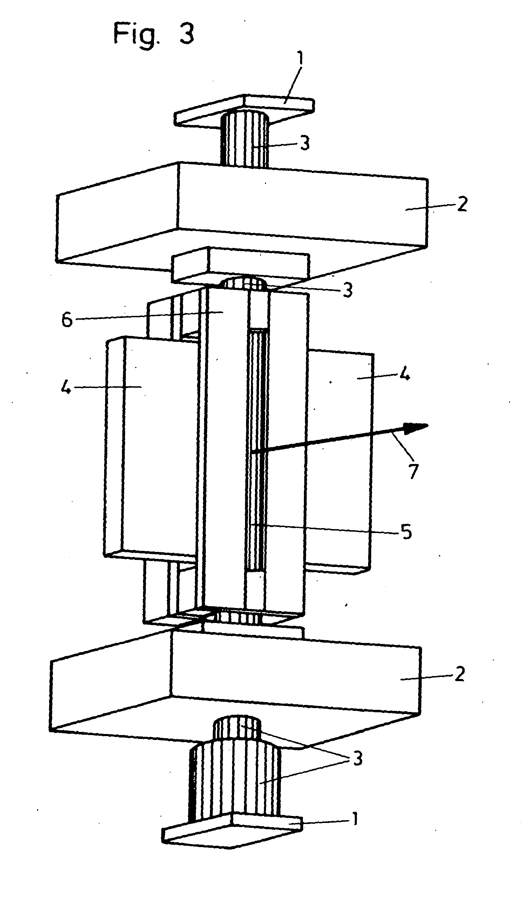

Die planare Magnetgeometrie ermöglicht bei mittlerem Leistungsaufwand, etwa 35 kW, in der Mittelebene des Luftspaltes von 20 cm Flussdichten um 0,5 T.
Ein vermaßtes Beispiel zeigt Figur 1. Das an sich wohlbekannte, geschlossene Weicheisenjoch, in dessen lichter Weite sich die beiden Magnetpole unter 20 cm Spaltbildung gegenüberstehen und zwischen denen die Elektrodenanordnung der Ionenquelle gemäß Figur 3 sitzt, hat flache Pole von 32 cm Breite x 8 cm Länge Querschnitt und damit ein Längen zu Breiten-Verhältnis von 8 : 32 = 1 : 4 = 0,25. Jeder Pol trägt eine magnetfelderzeugende Wicklung. Zwischen den beiden Polen bildet sich bei Bestromung der beiden Spulen das zur Magnetfeldachse symmetrische, jedoch in Richtung der Extraktionsachse stark abgeflachte Flaschen- bzw. Spiegelmagnetfeld aus (siehe Fig. 2). Zwischen den beiden Magnetfeldpolen sitzt die Elektrodenanordnung der Ionenquelle, wobei die Achse der Elektrodengeometrie mit der Magnetfeldachse zusammenfällt. Die Vermaßung des planaren Magneten ist in cm angegeben und beispielhaft.

Figur 2 zeigt die mit der Geometrie aus Figur 1 erreichte Feldverteilung in der Mittelebene zwischen den beiden Magnetpolen. Die x-Achse liegt parallel zu der großen Hauptachse der Stirnfläche eines Magnetpols, die y-Achse liegt parallel zur Extraktionsachse. Der eisenlose Spalt, der Luftspalt, zwischen den beiden Magnetfeldpolen ist hier 20 cm. Der eingezeichnete dicke Pfeil deutet die Extraktionsrichtung 7 an.

Figur 3 zeigt die Multi-Mode-Ionen-Quelle schematisch in Parallelperspektive, und zwar nur die Elektrodenanordnung. Diese sitzt zwischen den beiden Magnetfeldpolen aus Figur 1, so dass die Extraktionsachse 7 des Ionenstrahls dort senkrecht zur Bildebene steht. Die Ionen für den Ionenstrahl werden in dem Elektrodenzwischenbereich der beiden Anoden 2, der dazwischensitzenden Antikathode 6 und den beiden in die Antikathode 6 von links und rechts einmündenden Sputterelektroden 4 erzeugt. Die Sputterelektrode 4 besteht aus der außerhalb der Antikathode 6 liegenden Halterung/Stromzuführung, die an ihrer freien Stirn den Klotz aus dem vorgesehen Sputtermaterial aufgesetzt hat, der mit seiner freien Stirn wiederum unter Wahrung eines Isolationsspaltes zur umgebenden Antikatode 6 mit der Innenwand derselben bündig abschließt.

Die Plasmasäule 3 geht durch die beiden Anoden 2 hindurch und ragt oben und unten in der Figur 3 über die jeweilige Anode 2 hinaus. Sie ist durch die längsgeriffelte Welle nicht wirklichkeitsgetreu sondern lediglich stilisiert dargestellt und deutet damit einfach ihre zentrale Lage an. Die Plasmasäule 3 beginnt jeweils an den beiden Stirnflächen der Kathoden 1. Aus ihr werden in dem Antikathodenbereich die durch Sputtern aus der jeweiligen freien, in das Innere ragenden Stirn der beiden Sputterelektroden 4 Metallatome herausgeschlagen, im Plasma 3 im Bereich der Elektroden- bzw. Magnetfeldachse ionisiert und dann über die in der Figur 3 nicht eingezeichnete Extraktionselektrode (siehe beispielsweise DE 100 10 706) durch den noch freien, mittleren Längsspalt in der Antikathode 6 extrahiert. Die Metallionenstrahlachse, die Extraktionsachse 7, ist, ausgehend von der Mitte dieses Extraktionsspalts, durch die in den Bildvordergrund weisende Gerade angedeutet. Die gesamte Elektrodenanordnung einschließlich der Kathoden 1 sitzt spiegelbildlich zur Mittenebene des Spaltes zwischen den beiden Magnetfeldpolen.

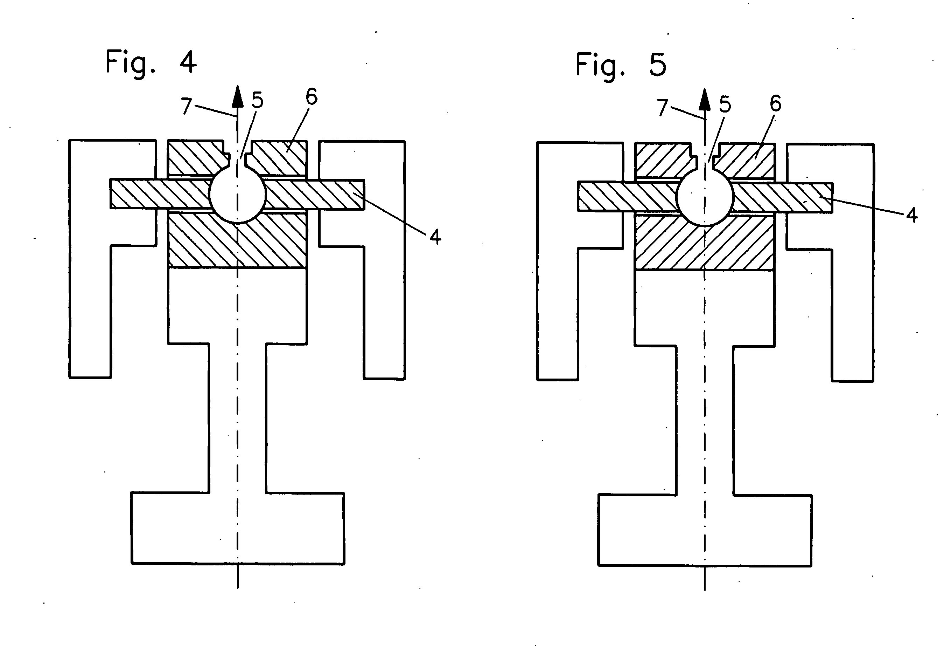

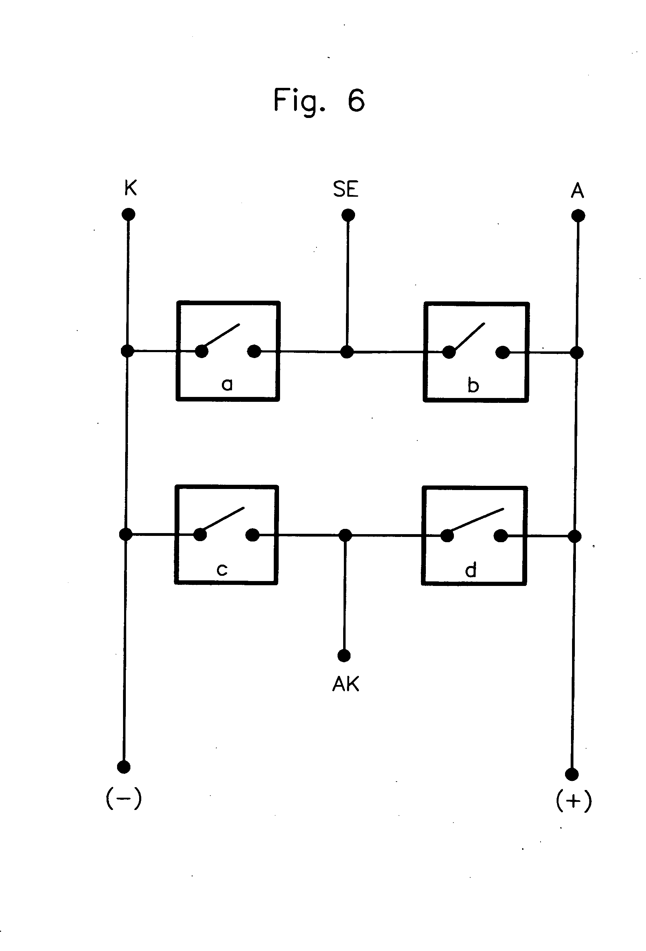

Mit den beiden Figuren 4 und 5 werden zwei Beispiele für die Potentialbelegung der an der Metallionenerzeugung unmittelbar beteiligten Elektroden aus Figur 3 vorgestellt und zeigen daher den Schnitt durch diese Elektroden in der Mittenebene. Die beiden Elektroden, die Antikathode 6 und die Sputterelektrode 4 können wahlweise mit Anoden- oder Kathodenpotential belegt werden, falls die Elektroden 4 und 6 über die Schalter a bis d gemäß Figur 6 so mit diesen beiden Potentialen elektrisch verbunden sind. Gemäß Figur 4 ist der D-HCD-Betrieb eingestellt, d.h. Schalter a und c sind geschlossen, beide Elektroden 4 und 6, liegen auf Kathodenpotential.
In Figur 5 ist der PIG-Betrieb eingestellt. Das wird erreicht, indem die Antikathode 6 auf Anodenpotential liegt und die Sputterelektrode 4 auf Kathodenpotential. Hierzu müssen die Schalter a und d geschlossen sein. Um den PIG-Betrieb fahren zu können, müssen die Elektroden 4 und 6 potentialfrei montiert sein.

Nach Figur 6 gibt es, kombinatorisch betracht, sechs mögliche Schalterpaarstellungen, und zwar:
- Schalter a und b geschlossen, Schalter c und d geöffnet - verboten, weil Kurzschluss;
- Schalter a und c geschlossen, Schalter b und d geöffnet - möglich, D-HCD-Betrieb;
- Schalter a und d geschlossen, Schalter b und c geöffnet - möglich, PIG-Betrieb;
- Schalter b und c geschlossen, Schalter a und d geöffnet - möglich, aber nicht relevant;
- Schalter b und d geschlossen, Schalter a und c geöffnet - möglich, Gas-PIG-Betrieb;
- Schalter c und d geschlossen, Schalter a und b geöffnet - verboten, weil Kurzschluss.

Die Situation: Schalterpaar b und c geschlossen und Schalterpaar a und d geöffnet, ist eine mögliche Schalterpaarstellung, aber deshalb nicht relevant, weil für die Metallionenproduktion nicht von Interesse.

Figur 7 zeigt den Ionenstrom in Teilchen/s über der Extraktionsspannung in kV, und zwar die Ladungsverteilung im Ionenstrahl aus der D-HCD-Ionenquelle beim Betrieb im homogenen Magnetfeld, dargestellt durch die Spitzen von Mo¹⁺ bis Mo⁵⁺. Wird die Antikathode 6 auf Anodenpotential geschaltet, verschwindet das Metallionenspektrum nahezu vollständig und die Ionenquelle arbeitet als klassische Penning-Ionenquelle mit adäquater Ladungsverteilung der Ionen des Trägergases, Argon in Figur 7 und Xenon in Figur 8.

Figur 8 zeigt die Ladungsverteilung des Ionenstrahls aus der D-HCD-Ionenquelle beim Betrieb im symmetrischen Flaschenfeld des Kompaktmagneten bei ca. 0,15 T Flussdichte in der Mittenebene des Feldes. Hier dominiert der Hohlkathoden-Entladungsmodus, d. h. niedere Ladungszustände werden bevorzugt erzeugt (siehe die zunehmend höheren Spitzen von Mo⁴⁺ bis hin zu Mo¹⁺) . Wird die Antikathode 6 der Ionenquelle auf Anodenpotential geschaltet, verschwindet das Spektrum der Metallionen nahezu vollständig und es erscheint die Ladungsverteilung der Ionen des Trägergases, und zwar hier die Ionenteilchenspitzen Xe⁶⁺ bis Xe²⁺.

### Bezugszeichenliste:

- 1: Kathode
- 2: Anode
- 3: Plasma, Plasmasäule
- 4: Sputterelektrode, SE
- 5: Extraktionsspalt
- 6: Antikathode, AK
- 7: Extraktionsrichtung, Extraktionsachse

## Patentansprüche

1. Multi-Mode-Metall-Ionenquelle mit der Struktur einer Hohlkathoden-Sputter-Ionenquelle mit radialer Ionenextraktion, wahlweise betreibbar als Gas-Penning-Ionenquelle (Penning-Ion-Gauge, PIG) oder Sputter-Penning-Ionenquelle oder Hohlkathoden-Ionenquelle (Hollow-Cathode-Discharge, Dual HCD) bestehend aus:
- einer Einrichtung zur Erzeugung eines symmetrischen magnetischen Spiegelfeldes in einem Luftspalt eines Elektromagneten;
- einer Elektrodenanordnung (1, 2, 4, 6), die im Bereich des Spiegelfeldes enthalten ist und die zur Mittelebene des magnetischen Spiegelfeldes eine symmetrische Elektrodengeometrie (D-HCD) aufweist, deren Achse mit der magnetischen Achse des Spiegelfeldes zusammenfällt, wobei, ausgehend von den Rändern der Polschuhe des Elektromagneten, zwei gekühlte Kathoden (1) enthalten sind, wobei mindestens eine davon indirekt beheizbar ist;
- zwei, zwischen den Kathoden (1) angeordneten, gekühlten Anoden (2);
- einer hohlzylindrischen, zwischen den Anoden (2) angeordneten, gekühlten Antikathode (6), welche mit drei axialen Spalten (5) versehen ist, wovon der mittlerere Spalt (5) für die radiale Ionenextraktion Verwendung findet;
- zwei weiteren gekühlten Sputterelektroden (4), die in ihrem jeweiligen Stirnbereich einen Querschnitt derart haben, dass jede durch einen der beiden außenliegenden Spalte in der Antikathode (6) mit der Stirn bündig zur Innenwand ragen, die Antikathode (6) jedoch nicht unmittelbar berühren;
- einer Extraktionselektrode (7) außerhalb der Elektrodenanordnung (1, 2, 4, 6) vor dem mittleren Spalt (5) in der Antikathode (6), durch die hindurch die Ionen bei entsprechender elektrischer Potentialbeaufschlagung extrahiert werden;
- einer Schalteinrichtung mit vier Schaltern, wovon zwei auf kathodischem Potential und zwei auf anodischem Potential ansetzen, wobei zwei Schaltergruppen gebildet sind, bei denen jeweils ein Schalter auf Kathodenpotential mit einem auf Anodenpotential unter Wahrung des stets komplementären Schaltzustandes zueinander direkt verbunden ist, und die Sputterelektrode (4) an die Direktverbindung der einen Schaltergruppe und die Antikathode an die der andern Gruppe angeschlossen ist, wobei die Einrichtung zur Erzeugung des Magnetfelds derart gestaltet ist, daß zur Erzielung von Feldstärken um 0,5 T in der Mittelebene des Luftspaltes, in Richtung der Extraktionsachse (7) gesehen, das Längen- zu Breitenverhältnis der Polschuhfläche < 1 ist, wobei die Magnetfeldachse mit der Symmetrieachse der Elektrodenanordnung zusammenfällt und die Extraktionsachse in der Mittelebene liegt.

2. Multi-Mode-Metall-Ionenquelle nach Anspruch 1, **dadurch gekennzeichnet,**
**dass** die Einrichtung zum Erzeugen des magnetischen Spiegelfeldes konstruktiv derart gestaltet ist, dass der Querschnitt des das Spiegelfeld erzeugenden ebenen Polschuhs von rechteckig bis elliptisch ausgebildet ist.

3. Multi-Mode-Metall-Ionenquelle nach Anspruch 2, **dadurch gekennzeichnet,**
**dass** der Eisenkern der Einrichtung zum Erzeugen des magnetischen Spiegelfeldes aus einem C-Kern oder zwei in einer Ebene spiegelbildlich zueinander stehenden C-Kernen besteht, die einen gemeinsamen Luftspalt bilden.

4. Multi-Mode-Metall-Ionenquelle nach Anspruch 3, **dadurch gekennzeichnet,**
**dass** zwischen den beiden Polschuhen und der Elektrodenanordnung ein Dielektrikum sitzt.

## Claims

1. Multi-mode metal ion source having the construction of a hollow cathode sputter ion source with radial ion extraction, which can be selectively operated as a gas Penning ion gauge (PIG) ion source or as a sputter Penning ion gauge ion source or as a hollow cathode discharge (dual HCD) ion source,
consisting of:
- a means for generating a symmetrical magnetic mirror field in an air gap of an electromagnet;
- an electrode arrangement (1, 2, 4, 6), which is contained in the region of the mirror field, and has an electrode geometry (D-HCD) which is symmetric about the central plane of the magnetic mirror field and the axis of which is coincident with the magnetic axis of the mirror field, wherein two cooled cathodes (1) starting from the edges of the pole pieces of the electromagnet are contained, it being possible for at least one of said cathodes to be heated indirectly;
- two cooled anodes (2) which are arranged between the cathodes (1);
- a hollow, cylindrical, cooled anticathode (6) which is arranged between the anodes (2) and is provided with three axial gaps (5), of which the central gap (5) is used for radial ion extraction;
- two further cooled sputter electrodes (4), which have a cross-section in the respective end regions thereof such that each of them projects through one of the two outer gaps in the anticathode (6) with the end flush with the inner wall, but which do not contact the anticathode (6) directly;
- an extraction electrode (7) outside the electrode arrangement (1, 2, 4, 6) in front of the central gap (5) in the anticathode (6), through which the ions are extracted at a corresponding potential charge;
- a switching means with four switches, of which two are set to the cathodic potential and two are set to the anodic potential, forming two groups of switches, in each of which a switch at cathodic potential is directly connected to a switch at anodic potential so as to ensure that the switching states thereof are always complementary to one another, and the sputter electrode (4) being attached to the direct connection of one switch group and the anticathode being attached to that of the other group, the means for generating the magnetic field being formed in such a way that in order to achieve field strengths of about 0.5 T in the central plane of the air gap, as seen in the direction of the extraction axis (7), the length-to-width ratio of the pole piece surface is < 1, the magnetic field axis being coincident with the axis of symmetry of the electrode arrangement and the extraction axis lying in the central plane.

2. Multi-mode metal ion source according to claim 1, **characterised in that** the means for generating the magnetic mirror field is formed with a construction such that the cross-section of the planar pole piece generating the mirror field has a rectangular to elliptical shape.

3. Multi-mode metal ion source according to claim 2, **characterised in that** the iron core of the means for generating the magnetic mirror field consists of a C-core or of two C-cores which are arranged symmetrically to one another in a plane and which together form a single air gap.

4. Multi-mode metal ion source according to claim 3, **characterised in that** a dielectric is present between the two pole pieces and the electrode arrangement.

## Revendications

1. Source d'ions métalliques multimode ayant la structure d'une source d'ions à pulvérisation à cathode creuse avec extraction radiale des ions, qui peut être exploitée sélectivement comme source d'ions à gaz de type « piège de Penning » (PIG - Penning Ion Gauge) ou comme source d'ions à pulvérisation de type « piège de Penning » ou comme source d'ions à décharge à cathode creuse (double HCD - Hollow Cathode Discharge), consistant en :
- un moyen servant à générer un champ magnétique miroir symétrique dans un intervalle d'un électroaimant ;
- un agencement d'électrodes (1, 2, 4, 6) qui est contenu dans la zone du champ miroir et possède une géométrie d'électrodes (D-HCD) laquelle présente une symétrie au plan central du champ magnétique miroir et dont l'axe coïncide avec l'axe magnétique du champ miroir, dans lequel sont contenues deux cathodes refroidies (1) à partir des bords des pièces polaires de l'électroaimant, dans lequel au moins une des dites cathodes peut être chauffée indirectement ;
- deux anodes refroidies (2) qui sont agencées entre les cathodes (1) ;
- une anticathode creuse, cylindrique, refroidie (6) qui est agencée entre les anodes (2) et pourvue de trois intervalles axiaux (5), l'interstice central (5) étant utilisé pour l'extraction radiale des ions ;
- deux autres électrodes à pulvérisation refroidies (4), ayant une section transversale au niveau de leur zones d'extrémités respectives faisant que chacune d'entre elles fait saillie par l'un des deux intervalles externes dans l'anticathode (6) avec l'extrémité qui se trouve dans l'alignement de la paroi interne, mais n'entre pas en contact direct avec l'anticathode (6) ;
- une électrode d'extraction (7) à l'extérieur de l'agencement d'électrodes (1, 2, 4, 6) face à l'intervalle central (5) dans l'anticathode (6), par lequel les ions sont extraits suivant une charge potentielle correspondante ;
- un moyen de commutation avec quatre commutateurs dont deux sont réglés au potentiel cathodique et deux au potentiel anodique, formant ainsi deux groupes de commutateurs, où, dans chacun d'eux, un commutateur au potentiel cathodique est connecté directement à un commutateur au potentiel anodique pour faire en sorte que leurs états de commutation soient toujours complémentaires l'un de l'autre, et l'électrode de pulvérisation (4) étant fixée à la connexion directe d'un groupe de commutateurs tandis que l'anticathode est fixée à celle de l'autre groupe, le moyen servant à générer le champ magnétique étant conçu de manière que, pour atteindre des forces de champ d'environ 0,5 T dans le plan central de l'intervalle, observé dans le sens de l'axe d'extraction (7), le rapport longueur/largeur de la surface des pièces polaires est < 1, l'axe de champ magnétique coïncidant avec l'axe de symétrie de l'agencement d'électrodes et l'axe d'extraction se trouvant dans le plan central.

2. Source d'ions métalliques multimode selon la revendication 1, **caractérisée en ce que** le moyen servant à générer le champ magnétique miroir est structuré de manière que la section transversale de la pièce polaire plane générant le champ miroir ait une forme entre rectangulaire et elliptique.

3. Source d'ions métalliques multimode selon la revendication 2, **caractérisée en ce que** le noyau de fer du moyen servant à générer le champ magnétique miroir est constitué d'un noyau en C ou de deux noyaux en C lesquels sont agencés symétriquement l'un par rapport à l'autre dans un plan et forment ensemble un seul intervalle.

4. Source d'ions métalliques multimode selon la revendication 3, **caractérisée en ce qu'**un diélectrique est présent entre les deux pièces polaires et l'agencement d'électrodes.
